# EUROPÄISCHE PATENTSCHRIFT

(11) **EP 3 850 445 B1**
(45) Veröffentlichungstag und Bekanntmachung des Hinweises auf die Patenterteilung: **24.06.2026**
(21) Anmeldenummer: 19758894.0
(22) Anmeldetag: 20.08.2019
(51) Int. Cl.: G05B 19/042

(54) **ANTRIEBSSYSTEM UND VERFAHREN ZUR INBETRIEBNAHME EINES ANTRIEBSSYSTEMS MIT ELEKTROMOTOR UND ELEKTROGERÄT**
DRIVE SYSTEM AND METHOD FOR ACTUATING A DRIVE SYSTEM WITH AN ELECTRIC MOTOR AND ELECTRIC DEVICE
SYSTÈME D'ENTRAÎNEMENT ET PROCÉDÉ DE MISE EN SERVICE D'UN SYSTÈME D'ENTRAÎNEMENT COMPRENANT UN MOTEUR ÉLECTRIQUE ET UN APPAREIL ÉLECTRIQUE

(30) Priorität: 11.09.2018 DE 102018007177
(43) Veröffentlichungstag der Anmeldung: 21.07.2021
(73) Patentinhaber: SEW-EURODRIVE GmbH & Co. KG, 76646 Bruchsal (DE)
(72) Erfinder: MAYER, Ralph, 76698 Ubstadt-Weiher (DE)
(86) Internationale Anmeldenummer: PCT/EP2019/025277
(87) Internationale Veröffentlichungsnummer: WO 2020/052807

(56) Entgegenhaltungen:
- EP-A1- 0 896 265
- EP-A1- 1 929 380
- WO-A1-2007/006774
- DE-A1- 102007 058 880
- DE-A1- 102009 050 232
- DE-C1- 4 100 112
- US-A- 4 556 270

## Beschreibung

Die Erfindung betrifft ein Antriebssystem und ein Verfahren zur Inbetriebnahme eines Antriebssystems mit Elektromotor und Elektrogerät.

Es ist allgemein bekannt, dass ein Elektromotor von einem als Umrichter fungierenden Elektrogerät drehzahlgeregelt betreibbar ist.

**Aus der** WO 2007 / 006774 A1 **ist als nächstliegender Stand der Technik ein Speicher mit Datenabgleich aus einem und für einen Antriebsregler einer Maschine bekannt.**

Aus der DE 10 2006 051 371 A1 ist ein Gerät mit einem Modul bekannt, wobei Energie und Daten berührungslos übertragbar sind.

Aus der DE 10 2007 058 880 A1 ist ein Umrichtermotor bekannt.

Aus der DE 10 2009 050 232 A1 ist ein Elektrogerät bekannt.

Aus der DE 100 34 791 A1 ist eine tragbare Vorrichtung für einen Umrichter bekannt.

Aus der US 2005 / 0 021 909 A1 ist ein Speicherauswahlmittel bekannt.

Aus der EP 1 929 380 B1 ist ein Verfahren zur Inbetriebnahme eines Antriebs bekannt.

Aus der DE 1989 47 789 A1 ist eine Umrichterbaureihe bekannt.

**Aus der** DE 41 00 112 C1 **ist ein Steckverbinder mit einer Verriegelungsvorrichtung bekannt.**

**Aus der** US 4 556 270 A **ist ein Gehäuse eines Verbindungssteckers bekannt.**

Der Erfindung liegt daher die Aufgabe zugrunde, ein Antriebssystem weiterzubilden, wobei die Inbetriebnahme in einfacher Weise ausführbar sein soll.

Erfindungsgemäß wird die Aufgabe bei dem Antriebssystem nach den in Anspruch 1 und bei dem Verfahren nach den in Anspruch 8 angegebenen Merkmalen gelöst.

Wichtige Merkmale der Erfindung bei dem Antriebssystem mit Elektromotor und Elektrogerät, welches eine elektronische Schaltung aufweist, welche den Elektromotor speist,
wobei das Elektrogerät ein Modul aufweist,
wobei das Elektrogerät, insbesondere die elektronische Schaltung, zum Datenaustausch mit
einem Rechner, insbesondere Inbetriebnahme-PC, verbindbar ist, insbesondere zur Inbetriebnahme des Antriebssystems,
wobei das Modul in eine Vertiefung, insbesondere Ausnehmung, des Elektrogeräts eingesteckt ist,
wobei das Modul betätigbare Schalter, insbesondere DIP-Schalter, aufweist, und einen Speicher zur Speicherung von ersten Parametern aufweist.

Von Vorteil ist dabei, dass somit eine einfache Inbetriebnahme ausführbar ist. Denn entweder der Rechner ist zur Datenübertragung verbunden, so dass die Parameter an seiner Tastatur oder an seinem berührungssensitiven Bildschirm bequem und einer einfachen Menuführung folgend eingebbar sind, oder es müssen nur die DIP-Schalter gemäß Kennzeichnung am Gehäuseteil des Moduls oder gemäß Bedienungsanleitung und somit in einfacher Weise betätigt werden, so dass die im Modul gespeicherten Parameter sowie die durch die Schalterstellungen der DIP-Schalter codierten Parameter dem Elektrogerät zugeführt und zur Inbetriebnahme verwendet werden. Das Steckverbinden des Moduls in das Deckelteil des Elektrogeräts ist in einfacher Weise ausführbar, da nur das Deckelteil zu lösen ist und dann das Modul in die als Aufnahme für das Modul am Deckelteil ausgebildete Vertiefung oder Ausnehmung einzuführen ist.

Bei einer vorteilhaften Ausgestaltung weist wobei die elektronische Schaltung einen weiteren Speicher auf zur Speicherung von zweiten Parametern, insbesondere welche die ersten Parameter umfassen und auch den Schalterstellungen der Schalter entsprechende Parameter. Von Vorteil ist dabei, dass bei Vorhandensein des weiteren Speichers überflüssig ist, da die für die Inbetriebnahme notwendigen Parameter im weiteren Speicher hinterlegt sind. Denn dieser weitere Speicher ist langzeitstabil ausgelegt. Die Speicherung der in ihn eingeschriebenen Daten ist also dauerhaft und somit auch bei Stromausfall nicht gefährdet. Falls ein Rechner zur Datenübertragung verbunden wird, genießen die von ihm übertragenen Parameter eine höhere Priorität, so dass also die auf dem weiteren Speicher und die im Modul gespeicherten Parameter sowie die Schalterstellungen der DIP-Schalter für die Inbetriebnahme nicht verwendet werden.

Der weitere Speicher ist schon bei Produktion des Elektrogeräts mit Parametern versehbar und somit ein bautypabhängiger Zuordnungsfehler vermeidbar.

Außerdem ist eine besonders schnelle Datenübertragung ausführbar, da die Bandbreite der im Elektrogerät intern verlegten Datenkommunikationskanäle hoch ist.

Bei einer vorteilhaften Ausgestaltung weist das Elektrogerät ein Deckelteil auf, in welchem eine Leiterplatte der elektronischen Schaltung aufgenommen ist,
wobei eine Datenleitung, insbesondere zur Verbindung eines oder des Rechners mit der elektronischen Schaltung, durch eine Kabelverschraubung
   - des Deckelteils oder
   - eines Anschlussteils oder Anschlusskastenteils, auf welches das Deckelteil aufgesetzt ist,
durchgeführt ist. Von Vorteil ist dabei, dass die Leiterplatte vom Deckelteil geschützt umgeben ist, wobei das deckelteil wärmeleitend mit Wärme erzeugenden Bauteilen der elektronischen Schaltung verbindbar ist und somit eine effiziente Entwärmung ausführbar ist, wenn das Deckelteil an seiner Außenseite Kühlrippen aufweist.

**Erfindungsgemäß** weist das Modul zumindest einen Bügel auf, an dem eine Rastnase ausgeformt oder angeformt ist,
insbesondere wobei die Rastnase ein Isolationsteil hintergreift, welches zusammen mit dem Deckelteil die elektronische Schaltung gehäusebildend umgibt,
wobei der Bügel relativ zum Gehäuseteil des Moduls elastisch auslenkbar ist,
insbesondere wobei der Bügel einstückig am Gehäuseteil des Moduls ausgeformt oder angeformt ist. Von Vorteil ist dabei, dass das Modul einklipsbar verbindbar ist. Hierzu muss das Modul nur an seinen Bügeln gehalten werden, diese aufeinander zu gedrückt werden, um eine gewisse elastische Auslenkung zu erzielen und dann durch Einführen des Moduls in die Vertiefung eingeklipst werden.

**Erfindungsgemäß** sind am Gehäuseteil des Moduls Zapfen ausgeformt, welche in entsprechend langgestreckt ausgeformte Löcher beim Einführen des Moduls in die Vertiefung eingeführt werden. Von Vorteil ist dabei, dass eine Führung beim Einstecken des Moduls ausgebildet ist.

Bei einer vorteilhaften Ausgestaltung ist die Leiterplatte mit einem Steckverbinderteil bestückt, welches steckverbunden ist mit einem Gegensteckverbinderteil, welches in einem Anschlussteil oder Anschlusskastenteil, auf welches das Deckelteil aufgesetzt ist, angeordnet ist. Von Vorteil ist dabei, dass

**Erfindungsgemäß** weist die elektronische Schaltung ein Auswahlmittel auf, welches derart geeignet ausgeführt ist,
- dass bei vorhandenem, mit einem zum Datenaustausch mit der elektronischen Schaltung verbundenen Rechner die vom Rechner übertragenen Parameter zur Inbetriebnahme des Elektrogeräts verwendet werden
- und dass, falls dieser Rechner mit der elektronischen Schaltung zum Datenaustausch nicht verbunden ist, die in einem weiteren Speicher der elektronischen Schaltung vorhandenen Parameter zur Inbetriebnahme des Elektrogeräts verwendet werden
- und dass andernfalls, also bei deren Nicht-Vorhandensein oder bei Nicht-Vorhandensein des weiteren Speichers, die im dem Speicher des Moduls gespeicherten Parameter zur Inbetriebnahme verwendet werden.

Von Vorteil ist dabei, dass das Auswahlmittel zur Inbetriebnahme die Parameter nach ihrer Priorität auswählt, wobei der Rechner die höchste Priorität, der weitere Speicher eine niedrigere Priorität und der Speicher des Moduls die niedrigste Priorität aufweist.

Wichtige Merkmale bei dem Verfahren zur Inbetriebnahme eines Antriebssystems sind, dass die Inbetriebnahme des Elektrogeräts
- mit in einem Rechner gespeicherten Parametern durchgeführt wird, wenn der Rechner mit der elektronischen Schaltung zum Datenaustausch verbunden ist,
- mit in einem weiteren Speicher des Elektrogeräts gespeicherten Parametern durchgeführt wird, wenn ein solcher weitere Speicher vorhanden ist und Parameter zur Inbetriebnahme enthält und wenn der Rechner mit der elektronischen Schaltung zum Datenaustausch nicht verbunden ist,
- mit in dem Speicher des Moduls gespeicherten Parametern durchgeführt wird, wenn der weitere Speicher nicht vorhanden ist oder keine Parameter zur Inbetriebnahme enthält und wenn der Rechner mit der elektronischen Schaltung zum Datenaustausch nicht verbunden ist.

Von Vorteil ist dabei, dass eine Inbetriebnahme einfach und sicher ausführbar ist. Denn wenn ein Rechner verbunden ist, wird dieser für die Inbetriebnahme verwendet, also werden die Parameter am Rechner eingegeben oder dessen Parameter verwendet. Bei Nicht Vorhandensein dieser Inbetriebnahme-Möglichkeit werden die Parameter von dem weiteren Speicher gezogen, der im Elektrogerät schon vorgesehen ist. Falls auch diese Möglichkeit nicht ausführbar ist, werden die im Speicher des Moduls gespeicherten Parameter zusammen mit den Informationen über die Schalterstellungen der DIP-Schalter verwendet.

Bei einer vorteilhaften Ausgestaltung ist das Elektrogerät ein Deckelteil aufweist, in welchem eine Leiterplatte der elektronischen Schaltung aufgenommen,

wobei eine Datenleitung, insbesondere zur Verbindung des Rechners mit der elektronischen Schaltung, durch eine Kabelverschraubung des Deckelteils durchgeführt ist,

wobei die elektrischen Leitungen vom Deckelteil zum Anschlussteil oder Anschlusskastenteil durch eine Steckverbindung führen,
wobei die Inbetriebnahme bei abgesetztem Deckelteil, also aufgetrennter Steckverbindung, ausgeführt wird. Von Vorteil ist dabei, dass das Deckelteil bei aufgetrennter Steckverbindung parametrierbar ist und somit ohne Risiko, dass der Motor während der Parametrierung und Inbetriebnahme schon startet, die elektronische Schaltung in den beabsichtigten Betriebszustand gesetzt wird. Eine ausreichende Energieversorgung, die zwar nicht alle Bauelemente der elektronischen Schaltung vollständig versorgt, aber zumindest die für die Parametrierung notwendigen Bauelemente versorgt, wird über die Datenleitung zur Datenübertragung mit dem Rechner ausgeführt.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

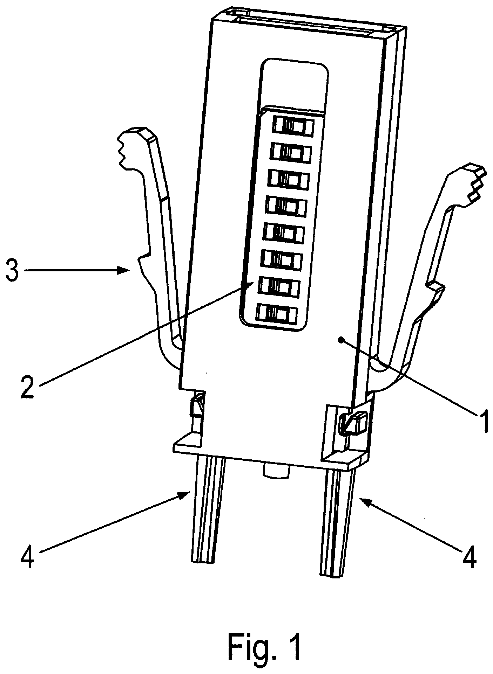

In der Figur 1 ist ein Modul 1 in Schrägansicht dargestellt.

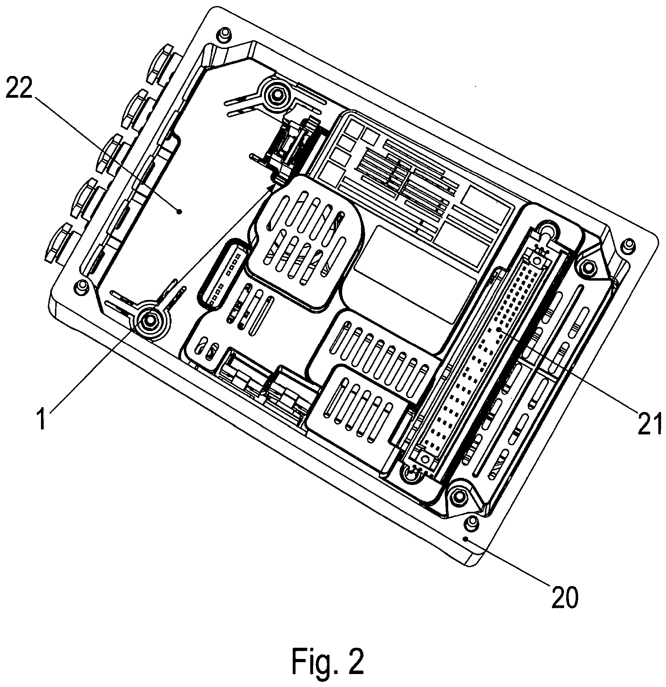

In der Figur 2 ist ein Deckelteil 20 mit eingestecktem Modul 1 in Schrägansicht dargestellt.

Wie in den Figuren dargestellt, ist in einem Deckelteil 20 eine Leiterplatte aufgenommen, auf welcher ein Steckverbinderteil 21 bestückt ist.

Das Deckelteil 20 ist somit aufsetzbar auf ein in den Figuren nicht dargestelltes Anschlussteil, welches ein mit dem Steckverbinderteil 21 in Steckverbindung bringbares, entsprechendes Gegensteckverbinderteil aufweist. Auf diese Weise ist ein Elektrogerät herstellbar, in dessen Anschlussteil Versorgungsleitungen und Datenleitungen hineinführbar sind, welche elektrisch verbunden sind mit Kontakten des Gegensteckverbinderteils, so dass die auf der Leiterplatte angeordnete elektronische Schaltung elektrisch versorgt ist.

Die Datenleitungen sind ebenso über die Steckverbindung der elektronischen Schaltung zuleitbar oder alternativ über Buchsen, welche in der Gehäusewand des Deckelteils 20 angeordnet sind und deren Kontakte mit Leiterbahnen der Leiterplatte elektrisch verbunden sind.

Alternativ ist das Deckelteil 1 auch aufsetzbar auf ein Anschlusskastenteil eines Elektromotors, welches ebenfalls die Funktionen und Ausstattungsmerkmale des Anschlussteils aufweist. Das Anschlusskastenteil ist mit einem den Stator des Elektromotors überdeckenden Motorgehäuseteil verbunden, insbesondere ist es einstückig und/oder einteilig mit ihm ausgeführt.

Somit ist ein Elektromotor integriert mit der elektronischen Schaltung ausführbar.

Insbesondere weist die elektronische Schaltung einen Wechselrichter auf, welcher einen oder den Elektromotor speist. Somit ist ein geregelter Betrieb des Elektromotors ausführbar entweder bei auf dem Anschlusskastenteil aufgesetztem deckelteil als Umrichtermotor oder alternativ bei auf das Anschlussteil aufgesetztem Deckelteil als Elektromotor mit abgesetztem, in der Anlage, also im Feld, angeordnetem, den Elektromotor speisenden Umrichter.

Das Modul 1 ist an der Unterseite, also an der nach Aufsetzen des Deckelteils 20 als Innenseite fungierenden Seite steckverbunden.

Hierzu weist das Isolationsteil 22, welches die Leiterplatte im Wesentlichen abdeckt und mit dem Deckelteil auf der dem Steckverbinderteil 21 zugewandten Seite der Leiterplatte verbunden ist, eine Ausnehmung auf.

Außerdem weist das Isolationsteil 22 eine weitere Ausnehmung für das Steckverbinderteil 21 auf.

Das Modul 1 weist einen Speicher auf, in welchem Parameter zur Inbetriebnahme der elektronischen Schaltung gespeichert sind. Darüber hinaus weist das Modul 1 Schalter 2, insbesondere DIP-Schalter, auf. Mit diesen sind Parameterwerte einstellbar, beispielsweise die Verschaltung des von der elektronischen Schaltung gespeisten Elektromotors, wobei als Verschaltung eine Sternschaltung oder eine Dreieckschaltung mittels eines oder mehrerer DIP-Schalter codierbar ist. Beispielhaft ist mit einem oder mehreren Schaltern die Motorschutzart einstellbar, insbesondere also die Art des die Temperatur des Motors überwachenden Sensors, insbesondere beispielhaft Temperaturfühlers, Heißleiters, Kaltleiters oder PK1000.

Das Modul 1 weist auch einen am Gehäuseteil des Moduls 1 befestigten und/oder ausgeformten, relativ zum Gehäuseteil des Moduls 1 elastisch auslenkbaren Bügel, insbesondere also Federbügel 3, auf. Der Bügel weist an seiner vom Gehäuseteil des Moduls abgewandten Seite eine Rastnase auf, so dass beim Einschieben des Moduls 1 in eine Vertiefung des Moduls 1, die Rastnase das Isolationsteil 22 hintergreift. Auf diese Weise ist ein Einrasten bewirkbar.

Des Weiteren weist das Modul 1 auch an der vom Bügel 3 abgewandten Seite des Moduls 1 einen weiteren Bügel auf, der ebenfalls elastisch auslenkbar zum Gehäuseteil und eine entgegengesetzt gerichtete Rastnase aufweist, so dass ein beidseitigen Einklipsen des Moduls 1 beim Einführen in die Vertiefung des Deckelteils 20 ermöglicht ist.

Somit ist also das Modul 1 einklipsbar ins Deckelteil 20.

Am Modul 1 sind Zapfen 4 ausgeformt, welche in entsprechend langgestreckt ausgeformte Löcher beim Einführen des Moduls 1 in die Vertiefung eingeführt werden, so dass das Modul 1 geführt einsteckbar ist ins Deckelteil 20, bis das Einklipsen bewirkt ist.

Die Bügel 3 weisen an ihrem von den Zapfen 4 abgewandten Endbereichen regelmäßig voneinander beabstandete Rillen auf, die quer zur Steckrichtung des Moduls 1 verlaufen.

Um ein einfach handhabbares Herauslösen des Moduls 1 aus dem Deckelteil 20 zu ermöglichen, ist die jeweilige Rastnase am jeweiligen Bügel 3 etwa mittig angeordnet und der jeweilige Endbereich des jeweiligen Bügels 3 verbreitert und mit einer geriffelten Fläche ausgeführt. Somit ist eine verbesserte Griffigkeit erreicht und eine Hebelwirkung, also der Bügel 3 mit geringem Kraftaufwand elastisch zum Gehäuseteil, also Grundkörper, des Moduls 1 hin drückbar, so dass die Einklipsverbindung lösbar ist.

Bei Inbetriebnahme eines Antriebs, also eines von der elektronischen Schaltung gespeisten Elektromotors, benötigt die elektronische Schaltung, insbesondere eine von ihr umfasste Regelvorrichtung für die Durchführung des geregelten Betriebs des Elektromotors, Parameter.

Wenn die elektronische Schaltung mittels der Datenleitungen mit einem außerhalb des Deckelteils 1 angeordneten Rechner verbunden ist, sind vom Rechner aus mittels einer geeigneten Software die Parameter übermittelbar, also die elektronische Schaltung vom Rechner aus parametrierbar.

Falls jedoch kein solcher Rechner mit der elektronischen Schaltung verbunden ist, wird überprüft, ob in der elektronischen Schaltung ein Speicher vorhanden ist, welcher die Parameter enthält. Falls dieser vorhanden ist, wird dieser zur Parametrierung verwendet.

Falls jedoch kein solcher Speicher vorhanden ist und auch keine solcher Rechner vorhanden ist, wird die Parametrierung durch Auslesen der auf dem Modul 1 gespeicherten und durch die DIP-Schalter 2 eingestellten Parameter ausgeführt.

Vorzugsweise führen die elektrischen Leitungen vom Deckelteil zum Anschlussteil oder Anschlusskastenteil durch einen Steckverbinder. Somit ist eine einfache Wartung ermöglicht.

Bei weiteren erfindungsgemäßen Ausführungsbeispielen fungiert das Gehäuseteil als Grundkörper, an dem die Zapfen 4 und die Bügel 3 samt Rastnasen einstückig, also einteilig, ausgeformt sind.

### Bezugszeichenliste

1 Modul
2 Schalter, insbesondere DIP-Schalter
3 Federbügel mit Rastnase
4 Zapfen
20 Deckelteil
21 Steckverbinderteil
22 Isolationsteil

## Patentansprüche

1. Antriebssystem mit Elektromotor und Elektrogerät, welches eine elektronische Schaltung aufweist, welche den Elektromotor speist,
wobei das Elektrogerät ein Modul (1) aufweist,
wobei das Elektrogerät, insbesondere die elektronische Schaltung, zum Datenaustausch mit einem Rechner, insbesondere Inbetriebnahme-PC, verbindbar ist, insbesondere zur Inbetriebnahme des Antriebssystems,
**wobei** das Modul (1) in eine Vertiefung, insbesondere Ausnehmung, des Elektrogeräts eingesteckt ist,
wobei das Modul (1) betätigbare Schalter (2), insbesondere DIP-Schalter, aufweist, und einen Speicher zur Speicherung von ersten Parametern aufweist, insbesondere mit welchen eine Inbetriebnahme des Elektrogeräts ausführbar ist,
**dadurch gekennzeichnet, dass**
**das Modul (1) zumindest einen Bügel aufweist, an dem eine Rastnase ausgeformt oder angeformt ist,**
**wobei der Bügel quer zur Steckrichtung des Moduls (1) sich erstreckende Rillen aufweist, insbesondere zur Erhöhung der Griffigkeit,**
**wobei der Bügel einstückig am Gehäuseteil des Moduls (1) ausgeformt ist,**
**wobei am Gehäuseteil des Moduls (1) Zapfen (4) ausgeformt sind, welche in entsprechend langgestreckt ausgeformte Löcher beim Einführen des Moduls (1) in die Vertiefung eingeführt werden,**
**wobei die elektronische Schaltung ein Auswahlmittel aufweist, welches derart geeignet ausgeführt ist,**
- **dass bei vorhandenem, mit einem zum Datenaustausch mit der elektronischen Schaltung verbundenen Rechner die vom Rechner übertragenen Parameter zur Inbetriebnahme des Elektrogeräts verwendet werden**
- **und dass, falls dieser Rechner mit der elektronischen Schaltung zum Datenaustausch nicht verbunden ist, die in einem weiteren Speicher der elektronischen Schaltung vorhandenen Parameter zur Inbetriebnahme des Elektrogeräts verwendet werden**
- **und dass andernfalls, also bei deren Nicht-Vorhandensein oder bei Nicht-Vorhandensein des weiteren Speichers, die im dem Speicher des Moduls (1) gespeicherten Parameter zur Inbetriebnahme verwendet werden.**

2. Antriebssystem nach Anspruch 1,
**dadurch gekennzeichnet, dass**
wobei die elektronische Schaltung einen weiteren Speicher aufweist zur Speicherung von zweiten Parametern, insbesondere welche die ersten Parameter umfassen und auch den Schalterstellungen der Schalter (2) entsprechende Parameter.

3. Antriebssystem nach einem der vorangegangenen Ansprüche,
**dadurch gekennzeichnet, dass**
das Elektrogerät ein Deckelteil (20) aufweist, in welchem eine Leiterplatte der elektronischen Schaltung aufgenommen ist,
wobei eine Datenleitung, insbesondere zur Verbindung eines oder des Rechners mit der elektronischen Schaltung, durch eine Kabelverschraubung
- des Deckelteils (20) oder
- eines Anschlussteils oder Anschlusskastenteils, auf welches das Deckelteil (20) aufgesetzt ist,
durchgeführt ist,
insbesondere wobei die elektrischen Leitungen vom Deckelteil (20) zum Anschlussteil oder Anschlusskastenteil durch einen Steckverbinder führen.

4. Antriebssystem nach einem der vorangegangenen Ansprüche,
**dadurch gekennzeichnet, dass**
**die Rastnase ein Isolationsteil (22) hintergreift, welches zusammen mit dem Deckelteil (20) die elektronische Schaltung gehäusebildend umgibt,**
**wobei der Bügel relativ zum Gehäuseteil des Moduls (1) elastisch auslenkbar ist.**

5. Antriebssystem nach Anspruch 4,
**dadurch gekennzeichnet, dass**
**die Rillen voneinander gleichmäßig und/oder regelmäßig beabstandet sind.**

6. Antriebssystem nach einem der vorangegangenen Ansprüche,
**dadurch gekennzeichnet, dass**
die Rillen am von den Zapfen (4) abgewandten Endbereichs des jeweiligen Bügels angeordnet sind.

7. Antriebssystem nach einem der vorangegangenen Ansprüche,
**dadurch gekennzeichnet, dass**
die Leiterplatte mit einem Steckverbinderteil (21) bestückt ist, welches steckverbunden ist mit einem Gegensteckverbinderteil, welches in einem Anschlussteil oder Anschlusskastenteil, auf welches das Deckelteil (20) aufgesetzt ist, angeordnet ist.

8. Verfahren zur Inbetriebnahme eines Antriebssystems nach einem der vorangegangenen Ansprüche,
**dadurch gekennzeichnet, dass**
die Inbetriebnahme des Elektrogeräts mit elektronischer Schaltung
- mit in einem Rechner gespeicherten Parametern durchgeführt wird, wenn der Rechner mit der elektronischen Schaltung zum Datenaustausch verbunden ist,
- mit in einem weiteren Speicher des Elektrogeräts gespeicherten Parametern durchgeführt wird, wenn ein solcher weitere Speicher vorhanden ist und Parameter zur Inbetriebnahme enthält und wenn der Rechner mit der elektronischen Schaltung zum Datenaustausch nicht verbunden ist,
- mit in dem Speicher des Moduls (1) gespeicherten Parametern durchgeführt wird, wenn der weitere Speicher nicht vorhanden ist oder keine Parameter zur Inbetriebnahme enthält und wenn der Rechner mit der elektronischen Schaltung zum Datenaustausch nicht verbunden ist.

9. Verfahren nach Anspruch 8,
**dadurch gekennzeichnet, dass**
das Elektrogerät ein Deckelteil (20) aufweist, in welchem eine Leiterplatte der elektronischen Schaltung aufgenommen ist,
wobei eine Datenleitung, insbesondere zur Verbindung des Rechners mit der elektronischen Schaltung, durch eine Kabelverschraubung des Deckelteils (20) durchgeführt ist,
wobei die elektrischen Leitungen vom Deckelteil (20) zum Anschlussteil oder Anschlusskastenteil durch eine Steckverbindung führen,
wobei die Inbetriebnahme bei abgesetztem Deckelteil (20), also aufgetrennter Steckverbindung, ausgeführt wird.

## Claims

1. A drive system with an electric motor and electrical device which has an electronic circuit which feeds the electric motor,
wherein the electrical device has a module (1),
wherein the electrical device, in particular the electronic circuit, is connectable for data exchange to a computer, in particular startup PC, in particular for starting up the drive system,
wherein the module (1) is inserted into a depression, in particular cutout, in the electrical device,
wherein the module (1) has actuatable switches (2), in particular DIP switches, and a memory for storing first parameters, in particular with which the electrical device can be started up,
**characterised in that**
the module (1) has at least one clip, on which a latching lug is formed or moulded on,
the clip having grooves extending transversely to the direction of insertion of the module (1), in particular for increasing the grip,
with the clip being formed in one piece on the housing part of the module (1),
with pins (4) being formed on the housing part of the module (1) which are introduced into correspondingly elongately formed holes upon introduction of the module (1) into the depression,
with the electronic circuit having a selection means which is embodied suitably in such a way
- that, if a computer which is connected for data exchange to the electronic circuit is present, the parameters transmitted by the computer are used for starting up the electrical device
- and that, if this computer is not connected for data exchange to the electronic circuit, the parameters present in a further memory of the electronic circuit are used for starting up the electrical device
- and that otherwise, i.e. if these are not present or if the further memory is not present, the parameters stored in the memory of the module (1) are used for starting-up.

2. A drive system according to claim 1,
**characterised in that**
wherein the electronic circuit has a further memory for storing second parameters, in particular which comprise the first parameters and also parameters corresponding to the switch positions of the switches (2).

3. A drive system according to one of the preceding claims,
**characterised in that**
the electrical device has a cover part (20) in which a printed circuit board of the electronic circuit is received,
with a data line, in particular for connecting a or the computer to the electronic circuit, being passed through a cable gland
- of the cover part (20) or
- of a terminal part or terminal housing part on which the cover part (20) is placed, in particular with the electric lines leading from the cover part (20) to the terminal part or terminal housing part through a plug-in connector.

4. A drive system according to one of the preceding claims,
**characterised in that**
the latching lug engages behind an insulating part (22) which together with the cover part (20) surrounds the electronic circuit in a housing-forming manner,
with the clip being elastically deflectable relative to the housing part of the module (1).

5. A drive system according to claim 4,
**characterised in that**
the grooves are uniformly and/or regularly spaced apart from each other.

6. A drive system according to one of the preceding claims,
**characterised in that**
the grooves are arranged on the end region of the respective clip which faces away from the pins (4).

7. A drive system according to one of the preceding claims,
**characterised in that**
the printed circuit board is equipped with a plug-in connector part (21) which is plug-connected to a mating plug-in connector part which is arranged in a terminal part or terminal housing part on which the cover part (20) is placed.

8. A method for starting up a drive system according to one of the preceding claims,
**characterised in that**
the starting-up of the electrical device with electronic circuit
- is performed with parameters stored in a computer if the computer is connected for data exchange to the electronic circuit,
- is performed with parameters stored in a further memory of the electrical device if such a further memory is present and contains parameters for starting-up and if the computer is not connected for data exchange to the electronic circuit,
- is performed with parameters stored in the memory of the module (1) if the further memory is not present or does not contain any parameters for starting-up and if the computer is not connected for data exchange to the electronic circuit.

9. A method according to claim 8,
**characterised in that**
the electrical device has a cover part (20) in which a printed circuit board of the electronic circuit is received,
with a data line, in particular for connecting the computer to the electronic circuit, being passed through a cable gland of the cover part (20),
with the electric lines leading from the cover part (20) to the terminal part or terminal housing part through a plug-in connection,
with the starting-up being performed with the cover part (20) removed, i.e. with the plug-in connection severed.

## Revendications

1. Système d'entraînement avec moteur électrique et appareil électrique, lequel présente un circuit électronique, lequel alimente le moteur électrique,
lequel appareil électrique présente un module (1),
lequel appareil électrique, en particulier le circuit électronique, est connectable pour l'échange de données avec un ordinateur, en particulier un PC de mise en service, notamment pour la mise en service du système d'entraînement,
lequel module (1) est inséré dans une cavité, en particulier un évidement, de l'appareil électrique, lequel module (1) présente des interrupteurs actionnables (2), en particulier des interrupteurs DIP, et présente une mémoire pour le stockage de premiers paramètres, en particulier avec lesquels une mise en service de l'appareil électrique est exécutable,
**caractérisé en ce que** le module (1) présente au moins un étrier, sur lequel un ergot d'arrêt est formé ou moulé solidaire,
lequel étrier présente des rainures s'étendant transversalement à la direction d'insertion du module (1), en particulier pour augmenter la préhension,
lequel étrier est formé en une seule pièce sur la partie de boîtier du module (1),
des tenons (4) étant formés sur la partie de boîtier du module (1), lesquels sont insérésdans des trous formés allongés de manière correspondante lors de l'insertion du module (1) dans la cavité,
lequel circuit électronique présente un moyen de sélection, lequel est réalisé de manière appropriée,
- **en ce que**, en présence d'un ordinateur connecté pour l'échange de données avec le circuit électronique, les paramètres transmis par l'ordinateur sont utilisés pour la mise en service de l'appareil électrique
- et **en ce que**, si cet ordinateur n'est pas connecté au circuit électronique pour l'échange de données, les paramètres présents dans une autre mémoire du circuit électronique sont utilisés pour la mise en service de l'appareil électrique
- et qu'à défaut, c'est-à-dire en cas d'absence de ceux-ci ou en cas d'absence de l'autre mémoire, les paramètres stockés dans la mémoire du module (1) sont utilisés pour la mise en service.

2. Système d'entraînement selon la revendication 1, **caractérisé en ce que** le circuit électronique présente une autre mémoire pour le stockage de deuxièmes paramètres, en particulier lesquels comprennent les premiers paramètres et aussi des paramètres correspondant aux positions d'interrupteur des interrupteurs (2).

3. Système d'entraînement selon l'une des revendications précédentes, **caractérisé en ce que** l'appareil électrique présente une partie de couvercle (20), dans laquelle une carte de circuit imprimé du circuit électronique est reçue, une ligne de données, en particulier pour la connexion d'un ou de l'ordinateur avec le circuit électronique étant réalisée à travers un presse-étoupe
- de la partie de couvercle (20) ou
- d'une partie de raccordement ou partie de boîte de raccordement, sur laquelle la partie de couvercle (20) est montée,
en particulier les lignes électriques allant de la partie de couvercle (20) à la partie de raccordement ou partie de boîte de raccordement passent par un connecteur enfichable.

4. Système d'entraînement selon l'une des revendications précédentes, **caractérisé en ce que** l'ergot d'arrêt vient en prise derrière une pièce d'isolation (22), laquelle, avec la partie de couvercle (20), entoure le circuit électronique en formant un boîtier, lequel étrier est déformable élastiquement par rapport à la partie de boîtier du module (1).

5. Système d'entraînement selon la revendication 4, **caractérisé en ce que** les rainures sont espacées les unes des autres de manière uniforme et/ou régulière.

6. Système d'entraînement selon l'une des revendications précédentes, **caractérisé en ce que** les rainures sont disposées à l'extrémité de chaque étrier opposée aux tenons (4).

7. Système d'entraînement selon l'une des revendications précédentes, **caractérisé en ce que** la carte de circuit imprimé est équipée d'une partie de connecteur enfichable (21), laquelle est connectée par enfichage à une contre-partie de connecteur enfichable, laquelle est disposée dansune partie de raccordement ou partie de boîte de raccordement, sur laquelle la partie de couvercle (20) est montée.

8. Procédé de mise en service d'un système d'entraînement selon l'une des revendications précédentes, **caractérisé en ce que** la mise en service de l'appareil électrique avec circuit électronique
- est réalisée avec des paramètres stockés dans un ordinateur, lorsque l'ordinateur est connecté au circuit électronique pour l'échange de données,
- est réalisée avec des paramètres stockés dans une autre mémoire de l'appareil électrique, lorsqu'une telle autre mémoire est présente et contient des paramètres pour la mise en service et lorsque l'ordinateur n'est pas connecté au circuit électronique pour l'échange de données,
- est réalisée avec des paramètres stockés dans la mémoire du module (1), lorsque l'autre mémoire n'est pas présente ou ne contient pas de paramètres pour la mise en service et lorsque l'ordinateur n'est pas connecté au circuit électronique pour l'échange de données.

9. Procédé selon la revendication 8, **caractérisé en ce que** l'appareil électrique présente une partie de couvercle (20), dans laquelle une carte de circuit imprimé du circuit électronique est reçue,
dans lequel une ligne de données, en particulier pour la connexion de l'ordinateur avec le circuit électronique, est réalisée à travers un presse-étoupe de la partie de couvercle (20),
dans lequel les lignes électriques allant de la partie de couvercle (20) à la partie de raccordement ou partie de boîte de raccordement passent par une connexion enfichable,
dans lequel la mise en service est exécutée avec la partie de couvercle (20) séparée, c'est-à-dire avec la connexion enfichable déconnectée.
